# FASCICULE DE BREVET EUROPEEN

(11) **EP 0 673 102 B1**
(45) Date de publication et mention de la délivrance du brevet: **14.07.1999**
(21) Numéro de dépôt: 95420070.5
(22) Date de dépôt: 20.03.1995
(51) Int. Cl.: H02J 7/00, H01L 41/113

(54) **Dispositif piézoélectrique pour charger un accumulateur d'énergie électrique équipant un objet soumis à des vibrations**
Piezoelektrische Vorrichtung zum Laden eines elektrischen Speichers für ein schwingendes Objekt
Piezoelectric device for charging an electric accumulator of a vibrating object

(30) Priorité: 18.03.1994 FR 9403441
(43) Date de publication de la demande: 20.09.1995
(73) Titulaire: METRAVIB R.D.S. Société Anonyme, 69760 Limonest (FR)
(72) Inventeur: Permuy, Alfred, 92500 Rueil Malmaison (FR); Duperray, Bernard, F-01480 Ars (FR); Garnier, Bernard, F-73000 Chambery (FR)
(74) Mandataire: Thibault, Jean-Marc

(56) Documents cités:
- US-A- 3 456 134
- US-A- 4 870 700
- DATABASE WPI Week 7923 Derwent Publications Ltd., London, GB; AN 79-F0844B [23] & SU-A-618 717 (ABRAMOV ET AL) , 24 Juin 1978
- PATENT ABSTRACTS OF JAPAN vol. 18 no. 33 (E-1493) ,18 Janvier 1994 & JP-A-05 266930 (BROTHER IND LTD) 15 Octobre 1993,

## Description

La présente invention concerne le domaine technique des systèmes adaptés pour assurer le chargement d'un accumulateur d'énergie électrique équipant un objet au sens général soumis à des vibrations ou à des chocs.

L'objet de l'invention trouve une application particulièrement avantageuse dans le domaine des objets électriques dont le fonctionnement nécessite l'utilisation d'un accumulateur d'énergie, ces objets présentant un caractère portable ou un fonctionnement dans des endroits isolés, tout en étant soumis à des vibrations ou à des chocs. D'une manière illustrative mais non limitative, l'invention peut équiper des micro-ordinateurs portatifs, les appareils de radio-communication, tels que les téléphones et télécopieurs, les baladeurs, les postes de radio ou des bouées lumineuses.

L'un des problèmes majeurs que présentent ces types d'objets réside dans leur autonomie d'énergie de relativement faible durée.

Pour tenter de résoudre ce problème, l'état de la technique a proposé une première solution consistant à utiliser des éléments photo-électriques qui génèrent des courants de charge, en fonction de l'intensité de l'éclairement naturel ou artificiel. Ce type de chargeur équipe, notamment, des objets, tels que des montres ou des calculatrices.

Cette solution technique permet de générer uniquement des courants de valeurs faibles, à moins de constituer des panneaux photo-électriques de grande surface, ce qui n'est pas toujours possible, en raison du caractère portatif des objets. Il apparaît, également, que la génération efficace de charges est subordonnée à une orientation appropriée des capteurs dans le champ d'une lumière d'intensité suffisante, de sorte que cette solution technique ne peut pas être mise en oeuvre pour équiper divers objets portatifs dont l'utilisation peut être effectuée en l'absence d'une source lumineuse.

Il est connu, dans l'état de la technique, une autre solution consistant à utiliser, à l'aide de moyens thermoélectriques, la différence de température entre la chaleur du corps humain et la température ambiante. Outre le fait que ce genre de solution présente un faible rendement, le principe même de cette technique limite ses applications pratiquement aux montres-bracelets.

Il est connu, par ailleurs, une autre solution consistant à utiliser l'énergie des mouvements mécaniques qui sont induits sur un composant inertiel de l'objet par les mouvements naturels associés au transport de cet objet. Il est ainsi connu un dispositif visant à convertir les mouvements par voie électrodynamique et comportant un micro-rotor aimanté, se déplaçant à l'intérieur d'un bobinage de fils conducteurs de l'électricité. Les vibrations sont appliquées à l'objet et, par suite, au micro-rotor, de manière à obtenir l'apparition d'un courant électrique qui, après avoir été redressé et accumulé dans un condensateur, est transféré à une batterie. Il apparaît que le rendement de ce dispositif reste faible et que sa complexité, et donc sa fragilité, est importante. Il s'avère, en pratique, qu'une telle solution technique est limitée essentiellement à des applications horlogères qui requièrent des puissances limitées de l'ordre du microwatt.

Il est connu, par ailleurs, par le document **SU-A-618 717,** un dispositif pour charger un accumulateur d'énergie électrique, comportant une lame piézoélectrique dont une extrémité est liée à l'objet et dont l'autre extrémité est munie d'une masse. La lame est reliée à un circuit assurant la conversion des charges électriques apparaissant lorsque l'objet est soumis à une accélération. Le circuit de conversion des charges est constitué par un étage redresseur. Cette solution présente les mêmes inconvénients que ceux énoncés ci-dessus, dans la mesure où la puissance récupérée reste de l'ordre du microwatt, ce qui limite les applications de ce type de dispositif.

La présente invention vise donc à remédier aux inconvénients énoncés ci-dessus en proposant un dispositif, adapté pour charger un accumulateur d'énergie électrique équipant un objet, au sens général, soumis à des accélérations et capable de générer des puissances électriques suffisantes, par exemple de l'ordre de quelques milliwatts, pour permettre de charger ledit accumulateur d'énergie électrique.

Un autre objet de l'invention est d'offrir un dispositif pour charger un accumulateur d'énergie électrique offrant une grande fiabilité et simplicité de fabrication, tout en présentant l'avantage de ne pas alourdir les objets équipés du dispositif selon l'invention.

Pour atteindre ces objectifs, le dispositif selon l'invention comporte :
- au moins un élément piézoélectrique lié à l'objet, apte à osciller selon au moins un degré de liberté,
- une masse oscillante agissant sur l'élément piézoélectrique, de manière à assurer l'apparition de charges électriques lorsque l'objet est soumis à une accélération,
- et un circuit électrique de conversion des charges apparaissant, à la suite de l'oscillation de l'élément piézoélectrique, en un courant de charge de l'accumulateur d'énergie électrique, le circuit comportant, en entrée, un étage redresseur délivrant une tension continue.

Selon l'invention, le circuit de conversion comporte un convertisseur continu-continu interposé entre l'étage redresseur et l'accumulateur, présentant une impédance d'entrée de valeur constante et purement résistive et délivrant, en sortie, un courant moyen sensiblement proportionnel au carré de la tension délivrée par l'étage redresseur.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

La **fig. 1** est une vue schématique montrant un exemple d'application d'un dispositif piézoélectrique, conforme à l'invention, pour un objet portatif.

La **fig. 2** est une vue générale montrant un détail caractéristique du dispositif selon l'invention.

Les **fig. 3** et **4** sont des schémas explicitant deux variantes de réalisation d'un circuit de conversion conforme à l'invention.

La **fig. 5** est une vue schématique montrant un autre exemple de réalisation d'un dispositif piézoélectrique selon l'invention.

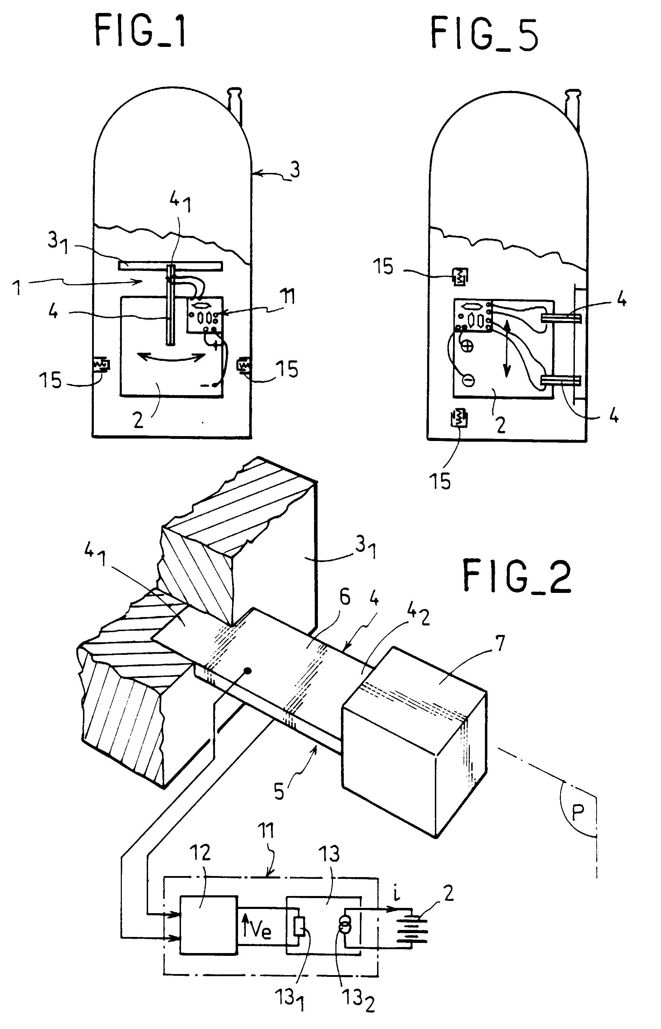

Tel que cela apparaît plus précisément à la **fig. 1**, le dispositif **1** selon l'invention est destiné à assurer le chargement d'un accumulateur d'énergie électrique **2** équipant un objet **3** au sens général, destiné à être soumis à des vibrations, à des chocs ou, d'une manière générale, à des accélérations. D'une manière classique, l'objet **3** comporte un accumulateur d'énergie électrique **2**, tel qu'une batterie, destiné à alimenter un circuit électrique spécifique assumant des fonctions appropriées adaptées à la nature de l'objet.

Le dispositif **1**, selon l'invention, de chargement de l'accumulateur **2**, comporte au moins un élément piézoélectrique **4** constitué, dans l'exemple illustré, par une lame liée, par l'une de ses extrémités **4**_{**1**}, à l'objet **3**. Dans l'exemple illustré, l'extrémité **4**_{**1**} de la lame est montée sur une platine **3**_{**1**} faisant partie de l'objet **3**. La lame piézoélectrique **4** comporte une paire d'armatures **5** et **6** déposées sur ses faces principales opposées, de sorte qu'il apparaît, sous l'influence d'une force, des charges de signe contraire sur les armatures et donc une différence de potentiel proportionnelle à la force appliquée. De préférence, la lame piézoélectrique **4** est constituée par l'intermédiaire d'une céramique ferroélectrique polarisée.

Bien entendu, il peut être mis en oeuvre une lame **4** constituée à partir d'une association de lamelles piézoélectriques, de manière à constituer un montage bimorphe ou multimorphe, soit parallèle, soit série. Dans le même sens, il peut être envisagé de réaliser la lame à partir d'un matériau souple ou élastique, sur lequel sont montées une ou plusieurs céramiques. Par ailleurs, il doit être considéré que l'élément piézoélectrique peut être réalisé sous une forme différente d'une lame. Il peut être prévu, ainsi, de mettre en oeuvre, pour l'élément piézoélectrique, par exemple, un assemblage de céramiques fonctionnant en traction-compression. Il peut être aussi envisagé de réaliser un système à bras de levier agissant sur l'élément piézoélectrique pour permettre de modifier la raideur du système ainsi réalisé.

Le dispositif selon l'invention comporte, également, une masse **7** adaptée pour agir sur l'élément piézoélectrique **4**, de manière à assurer l'apparition de charges électriques sur les armatures **5** et **6**, lorsque la lame est soumise à des accélérations consécutives à des vibrations de l'objet. Tel que cela apparaît plus précisément dans l'exemple illustré à la **fig. 2**, la masse oscillante **7** est montée en porte-à-faux sur la lame **4** en étant ancrée sur l'extrémité libre **4**_{**2**} de la lame, opposée de celle **4**_{**1**} ancrée à l'objet **3**. De préférence, la masse **7** est constituée par l'accumulateur **2**, de sorte que le poids de l'objet **3** n'est pas augmenté par l'incorporation d'une masse additionnelle. Dans le cas où l'élément piézoélectrique n'est pas réalisé sous la forme d'une lame, la masse **7** est montée de manière à agir sur l'élément piézoélectrique.

La lame piézoélectrique **4** travaille ainsi en flexion en supportant une masse **7** montée en porte-à-faux, permettant d'obtenir des mouvements de battement de la lame de relativement grande amplitude, par exemple de l'ordre de quelques centimètres. La lame **4** ainsi équipée est donc apte à osciller selon au moins un degré de liberté donné, considéré dans un plan privilégié de flexion **P**. La lame **4** est adaptée pour présenter des fréquences d'oscillation basses, afin de coïncider au mieux avec le contenu des sollicitations de transport, également de basse fréquence. Par exemple, la lame **4** est dimensionnée pour offrir une fréquence d'oscillation comprise entre 1 et 20 Hz et, de préférence, entre 5 et 10 Hz. Dans le même sens, la masse oscillante **7** est comprise entre 30 et 500 grammes et, de préférence, de l'ordre de 100 grammes.

Le dispositif selon l'invention comporte, également, un circuit électrique **11**, assurant une conversion des charges apparaissant aux bornes de la lame **4**, à la suite de son oscillation, en un signal de charge de la batterie **2**. Le dispositif piézoélectrique **1** selon l'invention permet ainsi d'assurer le chargement de la batterie **2** par la récupération des charges électriques dues aux mouvements d'accélération de la lame **4** et consécutifs aux différentes secousses ou vibrations que subit l'objet lors de son transport ou de son utilisation.

Dans l'exemple illustré plus précisément à la **fig. 2**, le circuit **11** de conversion comporte un circuit redresseur **12** permettant de cumuler les charges obtenues sur une période entière, dans la mesure où les mouvements oscillants génèrent des champs électriques opposés à chaque demie période d'oscillation de la lame. Le circuit redresseur **12** délivre une tension de sortie **Ve** qui est appliquée à l'entrée d'un circuit **13** conçu pour convertir le signal redressé en un courant de charge. A cet effet, le circuit de conversion **13** comporte une impédance d'entrée **13**_{**1**} adaptée aux caractéristiques électriques de la lame **4** et un générateur de courant **13**_{**2**} permettant de charger l'accumulateur **2**.

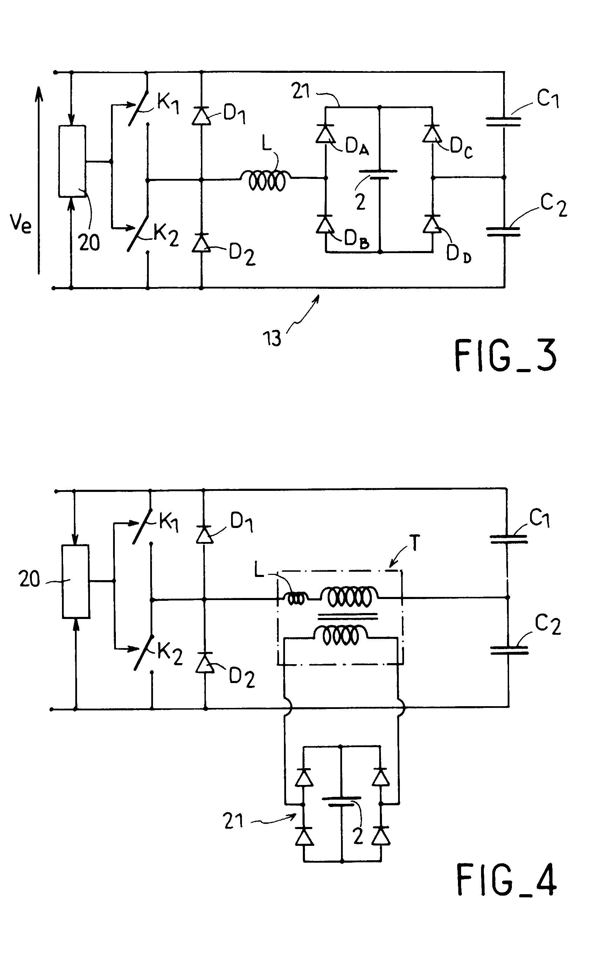

Tel que cela ressort plus précisément de la **fig. 3**, le circuit de conversion **13** constitue un convertisseur continu-continu interposé entre l'étage redresseur **12** et l'accumulateur **2**. Il doit être compris que le circuit **13** est adapté pour convertir le signal continu délivré par l'étage redresseur **12**, en un courant continu **i**, à savoir variant unidirectionnellement, de manière à recharger l'accumulateur **2** sous une tension imposée par cette dernière, et quelle que soit la tension délivrée par l'étage redresseur.

Selon l'invention, le convertisseur **13** doit présenter une impédance d'entrée purement résistive et dont la valeur est constante, quelle que soit l'amplitude de la tension d'entrée **Ve** délivrée par l'étage redresseur **12**. La valeur de cette résistance d'entrée est déterminée, d'une part, par les caractéristiques mécaniques du système masse-ressort équivalent à l'élément piézoélectrique équipé de sa masse et, d'autre part, par les caractéristiques des déplacements auxquels l'objet est soumis. En effet, il doit être considéré que la valeur de cette résistance d'entrée est calculée de manière à obtenir un facteur de surtension déterminé pour le résonateur mécanique formé par l'élément piézoélectrique. Le facteur de surtension et la fréquence de résonance d'un tel résonateur sont optimisés de façon à obtenir, pour une forme de spectre d'excitation donnée, une fraction déterminée de la puissance maximale définie par la valeur de la masse **7** et l'intensité de l'excitation vibratoire pour un déplacement minimal de la lame **4**.

Pour une gamme de fréquence d'excitation inférieure à 20 Hz et en se limitant à une puissance disponible, par exemple égale à 0,9 de la puissance maximale, le facteur de surtension peut prendre des valeurs inférieures à 10 avec une fréquence de résonance proche de 15 Hz. De préférence, pour une excitation uniforme entre 1 et 12 Hz, le facteur de surtension sera de l'ordre de 8 avec une fréquence de résonance d'environ 9 Hz. La valeur de la résistance d'entrée se déduit alors des caractéristiques mécaniques et électriques de la lame **4**, ainsi que des valeurs du facteur de surtension et de la fréquence de résonance.

Le convertisseur **13** présente une autre caractéristique qui est celle de délivrer, en sortie, aux pertes près, un courant moyen **i** sensiblement proportionnel au carré de la tension d'entrée **Ve**. Le courant **i** unidirectionnel alimente l'accumulateur **2** sous une tension imposée par l'accumulateur **2**.

Le convertisseur **13** selon l'invention est constitué par une alimentation à résonance permettant, d'une part, de présenter une impédance d'entrée purement résistive de valeur constante et, d'autre part, de délivrer un courant moyen proportionnel au carré de la tension d'entrée **Ve**. La structure et le fonctionnement d'une alimentation à résonance sont connus et décrits, notamment, dans le livre ALIMENTATION À DÉCOUPAGE - CONVERTISSEURS À RÉSONANCE - J.P. FERRIEUX & F. FOREST, Editions MASSON, 2ème Edition, 1994. La description qui suit, en référence à la **fig. 3**, décrit de manière succincte une alimentation à résonance appliquée à la charge d'une batterie **2**.

L'alimentation à résonance **13** comporte deux interrupteurs électroniques **K**_{**1**}, **K**_{**2**} montés en série entre les bornes de sortie de l'étage redresseur **12** délivrant la tension d'entrée **Ve**. Les interrupteurs **K**_{**1**}**, K**_{**2**} sont commandés en fonctionnement par un circuit de commande **20** piloté à partir de la tension d'entrée **Ve**, de sorte que la fréquence de commande des interrupteurs est proportionnelle à la tension d'entrée **Ve**.

L'alimentation à résonance comporte aussi deux redresseurs, tels que deux diodes **D**_{**1**}**, D**_{**2**} montées en parallèle, respectivement, avec les interrupteurs **K**_{**1**}, **K**_{**2**}. Deux condensateurs **C**_{**1**} et **C**_{**2**} de même valeur, montés en série, sont connectés entre les bornes de sortie de l'étage redresseur **12**. Une inductance **L**, montée en série avec un circuit redresseur **21** alimentant la batterie **2**, est reliée, d'une part, au point milieu des diodes **D**_{**1**} et **D**_{**2**} et des interrupteurs **K**_{**1**} et **K**_{**2**} et, d'autre part, au point milieu des condensateurs **C**_{**1**}, **C**_{**2**}.

Le circuit redresseur **21** est formé par un pont de quatre diodes **D**_{**A**}**-D**_{**D**}, dont la branche commune comporte la batterie **2**. D'une manière classique, les interrupteurs **K**_{**1**}**, K**_{**2**} sont commandés pour fonctionner en alternance. Ainsi, lorsque l'interrupteur **K**_{**1**} est commandé en mode de conduction, tandis que simultanément l'interrupteur **K**_{**2**} est bloqué, le courant traversant l'inductance **L** est formé de deux demi-sinusoïdes dont la fréquence est déterminée par les valeurs de l'inductance **L** et des condensateurs **C**_{**1**} et **C**_{**2**}. Lors de la première demi-période, la conduction est assurée par l'interrupteur **K**_{**1**} et le courant alimente la batterie **2** à travers les diodes **D**_{**A**} et **D**_{**D**}. Lors de la deuxième demi-période, la conduction est assurée par la diode **D**_{**1**} et l'interrupteur **K**_{**1**} peut alors être ouvert. Le courant alimente alors la batterie 2 à travers les diodes **D**_{**B**} et **D**_{**C**}. A la fin de la période complète, ni l'interrupteur **K**_{**1**}, ni la diode **D**_{**1**} ne conduisent et l'interrupteur **K**_{**2**} peut alors être fermé. Un fonctionnement identique à celui décrit ci-dessus se produit.

Le convertisseur à résonance décrit ci-dessus constitue un circuit optimisé pour récupérer l'énergie électrique délivrée par l'élément piézoélectrique.

La **fig. 4** illustre une autre variante de réalisation dans laquelle l'enroulement **L** est constitué par l'inductance de fuite du primaire d'un transformateur **T**, dont l'enroulement secondaire alimente le circuit redresseur **21**. La mise en oeuvre d'un transformateur **T** permet d'adapter les tensions à la tension de charge de la batterie **2**.

Selon une caractéristique avantageuse de l'invention, la lame **4** est limitée dans son mouvement d'oscillation, par l'intermédiaire de deux butées **15** placées dans le plan de flexion **P**, de part et d'autre de la lame **4**. Par exemple, les butées **15** sont placées de manière à venir en contact avec la masse oscillante **7**. De préférence, les butées **15** sont de nature élastique, permettant d'augmenter l'énergie récupérée et la fréquence d'oscillation de la masse **7**. Une telle disposition permet d'augmenter la puissance électrique disponible.

Dans l'exemple illustré, la lame piézoélectrique **4** est montée de manière à travailler en flexion dans un plan **P**, perpendiculaire à ses faces principales constituées par les électrodes **5** et **6**. Bien entendu, il peut être envisagé de constituer un élément piézoélectrique formé d'au moins deux lames piézoélectriques, montées de manière à présenter chacune un plan de flexion différent. Ainsi, il pourrait être envisagé de monter, sur la lame piézoélectrique **4**, une autre lame piézoélectrique décalée de 90°, dont le plan de flexion privilégié serait parallèle au plan des armatures, c'est-à-dire perpendiculaire au plan de flexion **P**. Une telle disposition offre l'avantage de pouvoir récupérer l'énergie des oscillations de la masse **7** se déplaçant dans les deux directions sus-indiquées.

Tel que cela ressort plus précisément du montage illustré à la **fig. 1**, le dispositif **1** est sensible aux sollicitations de translation, suivant un axe horizontal s'établissant dans le plan de la feuille. La **fig. 5** illustre un montage dans lequel le dispositif **1** est sensible aux sollicitations de translation suivant l'axe vertical. Dans cet exemple de réalisation, il est à noter que l'accumulateur **2** est supporté par deux lames **4** supportées en porte-à-faux par la platine **3**_{**1**}.

L'invention n'est pas limitée aux exemples décrits et représentés.

## Revendications

1. Dispositif piézoélectrique pour charger un accumulateur d'énergie électrique (**2**) équipant un objet (**3**) soumis à des accélérations, le dispositif comportant :
- au moins un élément piézoélectrique (**4**), lié à l'objet (**3**), apte à pouvoir osciller selon au moins un degré de liberté,
- une masse (**7**) agissant sur l'élément piézoélectrique, de manière à assurer l'apparition de charges électriques, lorsque l'objet est soumis à une accélération,
- et un circuit électrique (**11**) de conversion des charges apparaissant, à la suite de l'oscillation de l'élément piézoélectrique, en un courant de charge de l'accumulateur d'énergie électrique (**2**), le circuit comportant, en entrée, un étage redresseur (**12**) délivrant une tension continue,
caractérisé en ce que le circuit de conversion (**11**) comporte un convertisseur continu-continu (**13**) interposé entre l'étage redresseur (**12**) et l'accumulateur (**2**), présentant une impédance d'entrée de valeur constante et purement résistive et délivrant, en sortie, un courant moyen sensiblement proportionnel au carré de la tension délivrée par l'étage redresseur.

2. Dispositif selon la revendication 1, caractérisé en ce qu'il comporte deux butées limitant le déplacement de l'élément piézoélectrique (**4**).

3. Dispositif selon la revendication 2, caractérisé en ce que les butées (**15**) sont de nature élastique permettant d'augmenter la puissance électrique convertie.

4. Dispositif selon la revendication 1, caractérisé en ce que le convertisseur continu-continu (**13**) présente une impédance d'entrée résistive dont la valeur est déterminée en fonction des caractéristiques mécaniques de l'élément piézoélectrique associé à la masse.

5. Dispositif selon la revendication 1 ou 4, caractérisé en ce que le convertisseur continu-continu (**13**) est constitué par une alimentation à résonance comportant :
- deux interrupteurs électroniques (**K**_{**1**}**, K**_{**2**}) commandés et possédant chacun, en parallèle, deux redresseurs (**D**_{**1**}**, D**_{**2**}), montés en série entre les bornes de sortie de l'étage redresseur (**12**),
- deux condensateurs (**C**_{**1**}**, C**_{**2**}) montés en série entre les bornes de sortie de l'étage redresseur (**12**),
- une inductance (**L**) associée à un pont redresseur (**21**) alimentant l'accumulateur (**2**) et montée entre les points milieu des interrupteurs (**K**_{**1**}**, K**_{**2**}), d'une part, et des condensateurs (**C**_{**1**}**, C**_{**2**}), d'autre part.

6. Dispositif selon la revendication 5, caractérisé en ce que les interrupteurs électroniques (**K**_{**1**}**, K**_{**2**}) sont commandés à une fréquence proportionnelle à la tension d'entrée (**Ve**) du convertisseur, délivrée par l'étage redresseur.

7. Dispositif selon la revendication 6, caractérisé en ce que l'inductance (L) est constituée par l'inductance de fuite du primaire d'un transformateur (**T**_{**1**}), dont l'enroulement secondaire alimente le pont redresseur alimentant l'accumulateur (**2**).

8. Dispositif selon la revendication 1, caractérisé en ce que l'élément piézoélectrique (**4**) est une céramique ferroélectrique polarisée.

9. Dispositif selon la revendication 1 ou 8, caractérisé en ce que l'élément piézoélectrique (**4**) présente une fréquence d'oscillation comprise entre 1 et 20 Hz et, de préférence, entre 5 et 10 Hz, et se trouve équipée d'une masse comprise entre 30 et 500 grammes et, de préférence, de l'ordre de 100 grammes.

10. Dispositif selon la revendication 1, caractérisé en ce que l'élément piézoélectrique (**4**) et la masse (**7**) constituent un résonateur mécanique dont le facteur de surtension est inférieur à 10 et, de préférence, de l'ordre de 8.

## Patentansprüche

1. Piezoelektrische Vorrichtung zum Laden eines Speichers (2) elektrischer Energie, mit dem ein Beschleunigungen unterworfenes Objekt (3) versehen ist, mit
- wenigstens einem mit dem Objekt (3) verbundenen piezoelektrischen Bauteil (4), das Schwingungen mit wenigstens einem Freiheitsgrad auszuführen vermag,
- einer Masse (7), die auf das piezoelektrische Bauteil in einer das Auftreten elektrischer Ladungen sicherstellender Weise einwirkt, wenn das Objekt eine Beschleunigung erfährt, und
- einer elektrischen Schaltungsanordnung (11) zur Umwandlung der infolge der Schwingung des piezoelektrischen Bauteils auftretenden Ladungen in einen Ladestrom für den Speicher (2) elektrischer Energie, wobei die Schaltungsanordnung am Eingang eine Gleichrichterstufe (12) aufweist, die eine Gleichspannung liefert,
dadurch gekennzeichnet, daß die Wandlerschaltung (11) einen zwischen der Gleichrichterstufe (12) und dem Speicher (2) angeordneten Gleichspannungswandler (13) aufweist, der eine rein resistive Eingangsimpedanz von konstantem Wert besitzt und am Ausgang einen mittleren Strom liefert, der dem Quadrat der von der Gleichrichterstufe abgegebenen Spannung im wesentlichen proportional ist.

2. Vorrichtung nach Anspruch 1,
dadurch gekennzeichnet, daß sie zwei Anschläge aufweist, welche die Bewegung des piezoelektrischen Bauteils (4) begrenzen.

3. Vorrichtung nach Anspruch 2,
dadaurch gekennzeichnet, daß die Anschläge (15) von elastischer Art sind, die eine Erhöhung der umgewandelten elektrischen Leistung ermöglicht.

4. Vorrichtung nach Anspruch 1,
dadurch gekennzeichnet, daß der Gleichspannungswandler (13) eine resistive Eingangsimpedanz aufweist, deren Wert in Abhängigkeit von den mechanischen Eigenschaften des mit der Masse verbundenen piezoelektrischen Bauteils bestimmt ist.

5. Vorrichtung nach Anspruch 1 oder 4,
dadurch gekennzeichnet, daß der Gleichspannungswandler (13) von einer mitschwingenden Speisequelle gebildet ist, die umfaßt:
- zwei elektronische Schalter (K₁, K₂), die gesteuert werden und je zwei parallelgeschaltete Gleichrichter (D₁, D₂) aufweisen, welche in Serie an die Ausgangsklemmen der Gleichrichterstufe (12) angeschlossen sind,
- zwei Kondensatoren (C₁, C₂), die in Serie an die Ausgangsklemmen der Gleichrichterstufe (12) angeschlossen sind,
- eine Induktivität (L), die mit einer den Speicher (2) speisenden Gleichrichterbrücke (21) verbunden ist und zwischen den Mittelpunkten einerseits der Schalter (K₁ , K₂) und andererseits der Kondensatoren (C₁, C₂) angeordnet ist.

6. Vorrichtung nach Anspruch 5,
dadurch gekennzeichnet, daß die elektronischen Schalter (K₁, K₂) mit einer Frequenz gesteuert werden, die der von der Gleichrichterstufe gelieferten Eingangsspannung (Ve) des Wandlers proportional ist.

7. Vorrichtung nach Anspruch 6,
dadurch gekennzeichnet, daß die Induktivität (L) von der Streuinduktivität der Primärwicklung eines Transformators (T₁) gebildet ist, dessen Sekundärwicklung die den Speicher (2) speisende Gleichrichterbrücke versorgt.

8. Vorrichtung nach Anspruch 1,
dadurch gekennzeichnet, daß das piezoelektrische Bauteil (4) eine polarisierte ferroelektrische Keramik ist.

9. Vorrichtung nach Anspruch 1 oder 8,
dadurch gekennzeichnet, daß das piezoelektrische Bauteil (4) mit einer Frequenz zwichen 1 und 20 Hz, vorzugsweise zwischen 5 und 10 Hz schwingt und mit einer Masse von 30 bis 500 Gramm, vorzugsweise von etwa 100 Gramm versehen ist.

10. Vorrichtung nach Anspruch 1,
dadurch gekennzeichnet, daß das piezoelektrische Bauteil (4) und die Masse (7) einen mechanischen Resonator bilden, dessen Gütefaktor weniger als 10, vorzugsweise etwa 8 beträgt.

## Claims

1. A piezoelectric device for charging an electrical energy accumulator (2) fitted to an object (3) which is subjected to accelerations, the device comprising:
· at least one piezoelectric element (4) linked to the object (3) and suitable for oscillating with at least one degree of freedom;
· a mass (7) acting on the piezoelectric element so as to cause electric charge to appear thereon when the object is subjected to an acceleration; and
· an electrical converter circuit (11) for converting the electric charge which appears due to oscillation of the piezoelectric element into current for charging the electric energy accumulator (2), the circuit including, at its inlet, a rectifier stage (12) that delivers a DC voltage;
the device being characterized in that the converter circuit (11) has a DC-DC converter (13) interposed between the rectifier stage (12) and the energy accumulator (2), the converter having a purely resistive input impedance of constant value and delivering, at its output, a mean current that is substantially proportional to the square of the voltage delivered by the rectifier stage.

2. A device according to claim 1, characterized in that it has two abutments for limiting the displacement of the piezoelectric element (4).

3. A device according to claim 2, characterized in that the abutments (15) are elastic, enabling the amount of electrical power converted to be increased.

4. A device according to claim 1, characterized tn that the DC-DC converter (13) has resistive input impedance of resistance that is determined as a function of the mechanical characteristics of the piezoelectric element associated with the mass.

5. A device according to claim 1 or 4, characterized in that the DC-DC converter (13) is constituted by a resonant power supply comprising:
· two electronic controlled switches (K₁, K₂) connected in series across the output terminals of the rectifier stage (12), and each possessing a respective rectifier (D₁, D₂) connected in parallel therewith;
· two capacitors (C₁, C₂) connected in series across the output terminals of the rectifier stage (12); and
· inductance (L) associated with a rectifier bridge (21) feeding the energy accumulator (2) and connected between the midpoint between the switches (K₁, K₂) and the midpoint between the capacitors (C₁, C₂).

6. A device according to claim 5, characterized in that the electronic switches (K₁, K₂) are operated at a frequency that is proportional to the input voltage (Ve) to the converter as delivered by the rectifier stage.

7. A device according to claim 6, characterized in that the inductance (L) is constituted by the leakage inductance of the primary winding of a transformer (T₁) whose secondary winding feeds the rectifier bridge feeding the energy accumulator (2).

8. A device according to claim 1, characterized in that the piezoelectric element (4) is a polarized ferroelectric ceramic.

9. A device according to claim 1 or 8, characterized in that the piezoelectric element (4) has a frequency of oscillation lying in the range 1 Hz to 20 Hz, preferably in the range 5 Hz to 10 Hz, and is fitted with a mass lying in the range 30 grams (g) to 500 g, and preferably of about 100 g.

10. A device according to claim 1, characterized in that the piezoelectric element (4) and the mass (7) constitute a mechanical resonator whose Q-factor is less than 10 and is preferably about 8.
